# EUROPEAN PATENT APPLICATION

(11) **EP 4 564 669 A1**
(43) Date of publication of application: **04.06.2025**
(21) Application number: 24216237.8
(22) Date of filing: 28.11.2024
(51) Int. Cl.: H03K 17/0412, H02M 1/08, H03K 17/16

(54) **SWITCHED-MODE POWER SUPPLY**

(30) Priority: 29.11.2023 CN 202323241429 U
(71) Applicant: Anker Innovations Technology Co., Ltd., Changsha, Hunan 410000 (CN)
(72) Inventor: SHI, Qiuyue, Shenzhen (CN)
(74) Representative: Bittner, Thomas L.

(57) **Abstract**

A driving circuit for a switching device is provided. The driving circuit comprises a pulse width modulation circuit and a waveform conversion circuit. An output terminal of the pulse width modulation circuit is connected to an input terminal of the waveform conversion circuit, and an output terminal of the waveform conversion circuit is connected to a control terminal of the switching device. The waveform conversion circuit comprises a resistor-capacitor series circuit, the pulse width modulation circuit is configured to output a level pulse signal for turning on the switching device, and the resistor-capacitor series circuit is configured to reduce an edge slope of the level pulse signal.

## Description

The present application relates to a switched-mode power supply.

### Background

In high-speed switching applications, a switching device needs to quickly switch from an off state to an on state or from an on state to an off state. The quick switching process makes some parameters (e.g., parasitic parameters) such as capacitance, inductance, and resistance inside the switching device become important.

In a commonly used driving circuit for a switching device, due to the parameters of the switching device, high-frequency oscillation is produced at the moment of turning on the switching device in high-speed switching applications, resulting in electromagnetic interference, noise, and ringing formed by a driving waveform. Moreover, excessive peak voltage poses a risk of breakdown to the switching device.

### Summary

The present application is provided to solve at least one of the above problems.

According to an aspect of the present application, a driving circuit for a switching device comprises: a pulse width modulation circuit comprising an input terminal and an output terminal; and a resistor-capacitor series circuit comprising an input terminal and an output terminal, wherein: the output terminal of the pulse width modulation circuit is connected to an input terminal of the resistor-capacitor series circuit, the output terminal of the resistor-capacitor series circuit is connected to a control terminal of the switching device, the pulse width modulation circuit is configured to output a level pulse signal for turning on the switching device, and the resistor-capacitor series circuit is configured to reduce an edge slope of the level pulse signal.

The resistor-capacitor series circuit may comprise a first resistor and a first capacitor. A first terminal of the first resistor may be connected to the output terminal of the pulse width modulation circuit. A second terminal of the first resistor may be connected to a first terminal of the first capacitor. A second terminal of the first capacitor is connected to the control terminal of the switching device.

The driving circuit for the switching device may further comprise a waveform conversion circuit comprising a second resistor, wherein preferably the second resistor is connected in parallel to the first resistor and the first capacitor.

The driving circuit for the switching device may comprise a discharge circuit connected in parallel to the first resistor.

The discharge circuit may comprises a diode and/or a third resistor. A negative terminal of the diode may be connected to the first terminal of the first resistor. A positive terminal of the diode may be connected to a first terminal of the third resistor. A second terminal of the third resistor may be connected to the second terminal of the first resistor.

The pulse width modulation circuit may be configured to output a second level pulse signal for turning off the switching device. The second level pulse signal may be discharged by the discharge circuit, wherein preferably a level value of the level pulse signal is higher than that of the second level pulse signal.

The input terminal of the pulse width modulation circuit may be connected to an external power supply device.

An output terminal of the switching device may be connected to a voltage stabilizing input device. A ground terminal of the pulse width modulation circuit and/or an input terminal of the switching device may be connected to a ground node.

The switching device may comprise at least one of a metal oxide semiconductor field effect transistor (MOSFET), a junction field-effect transistor (JFET), and an insulated gate bipolar transistor (IGBT).

The control terminal may comprise a gate.

According to another aspect, a driving circuit for a switching device comprises: a pulse width modulation circuit configured to send a level pulse signal to the switching device; and a waveform conversion circuit connected to the pulse width modulation circuit, wherein the waveform conversion circuit comprises: a first resistor and a first capacitor connected in series, a second resistor connected in parallel to the first resistor and the first capacitor, and a diode and a third resistor connected in parallel to the first resistor.

The waveform conversion circuit may be configured to control an edge slope of the level pulse signal.

The waveform conversion circuit may be configured to reduce an edge slope of the level pulse signal.

The pulse width modulation circuit may be configured to send a second level pulse signal to the switching device, and preferably a level value of the level pulse signal may be higher than that of the second level pulse signal.

An output terminal of the switching device may be connected to a voltage stabilizing input device.

A ground terminal of the pulse width modulation circuit and/or an input terminal of the switching device may be connected to a ground node.

The switching device may comprise at least one of a metal oxide semiconductor field effect transistor (MOSFET), a junction field-effect transistor (JFET), and an insulated gate bipolar transistor (IGBT).

The switching device may comprise a gate connected to the waveform conversion circuit.

The waveform conversion circuit may be connected to a control terminal of the switching device.

The pulse width modulation circuit may be connected to an external power supply device.

According to an example, a driving circuit for a switching device may comprise at least one of: a pulse width modulation circuit, preferably comprising an input terminal and an output terminal; and a resistor-capacitor series circuit preferably comprising an input terminal and an output terminal. The output terminal of the pulse width modulation circuit may be connected to an input terminal of the resistor-capacitor series circuit and/or the output terminal of the resistor-capacitor series circuit may be connected to a control terminal of the switching device and/or the pulse width modulation circuit may be configured to output a level pulse signal for turning on the switching device and/or the resistor-capacitor series circuit may be configured to reduce an edge slope of the level pulse signal.

According to another example, a driving circuit for a switching device may comprise at least one of: a pulse width modulation circuit, preferably configured to send a level pulse signal to the switching device; and a waveform conversion circuit connected to the pulse width modulation circuit. The waveform conversion circuit may preferably comprise at least one of: a first resistor and a first capacitor connected in series, a second resistor connected in parallel to the first resistor and the first capacitor, and a diode and a third resistor connected in parallel to the first resistor.

According to another example, switched-mode power supply is provided. The switched-mode power supply comprises a driving circuit for a switching device. The driving circuit comprises a pulse width modulation circuit and a waveform conversion circuit, an output terminal of the pulse width modulation circuit is connected to an input terminal of the waveform conversion circuit, and an output terminal of the waveform conversion circuit is connected to a control terminal of the switching device. The waveform conversion circuit comprises a resistor-capacitor series circuit, the pulse width modulation circuit is configured to output a level pulse signal for turning on the switching device, and the resistor-capacitor series circuit is configured to reduce an edge slope of the level pulse signal.

According to another example, a switched-mode power supply is provided, wherein the switched-mode power supply comprises driving circuit for a switching device. The driving circuit for a switching device comprises a pulse width modulation unit and a first waveform conversion circuit, an output terminal of the pulse width modulation unit is connected to an input terminal of the first waveform conversion circuit, and an output terminal of the first waveform conversion circuit is connected to a control terminal of the switching device; and wherein the waveform conversion circuit comprises a resistor-capacitor series circuit, the pulse width modulation unit is used for outputting a first level pulse signal for turning on the switching device, and the resistor-capacitor series circuit is used for reducing an edge slope of the first level pulse signal.

In one example of the present application, the resistor-capacitor series circuit comprises a first resistor and a first capacitor, a first terminal of the first resistor is connected to the output terminal of the pulse width modulation circuit, a second terminal of the first resistor is connected to a first terminal of the first capacitor, and a second terminal of the first capacitor is connected to a control terminal of the switching device.

In one example of the present application, the switched-mode power supply includes a second waveform conversion circuit that comprises a second resistor, and the second resistor is connected in parallel to two ends of the resistor-capacitor series circuit.

In one example of the present application, the second resistor is connected in parallel to the two ends of the resistor-capacitor series circuit; when the resistor-capacitor series circuit smooths and delays a high-level pulse signal, a portion of the voltage divided by the second voltage falls onto the second resistor.

In one example of the present application, the switched-mode power supply comprises a third waveform conversion circuit, the third waveform conversion circuit comprises a discharge circuit, and the discharge circuit is connected in parallel to two ends of the first resistor.

In one example of the present application, the discharge circuit comprises a first diode and a third resistor, a negative terminal of the first diode is connected to the first terminal of the first resistor, a positive terminal of the first diode is connected to a first terminal of the third resistor, and a second terminal of the third resistor is connected to the second terminal of the first resistor.

In one example of the present application, the pulse width modulation circuit is further configured to output a second level pulse signal for turning off the switching device, and the second level pulse signal is discharged by the discharge circuit, where the level value of the first level pulse signal is higher than that of the second level pulse signal.

In one example of the present application, the input terminal of the pulse width modulation circuit is connected to an external power supply device.

In one example of the present application, an output terminal of the switching device is connected to a voltage stabilizing input device, and a ground terminal of the pulse width modulation circuit and an input terminal of the switching device are connected to a ground node.

In one example of the present application, the switching device is a metal oxide semiconductor field-effect transistor.

In one example of the present application, the switching device is one of an MOSFET, JFET or IGBT.

In one example of the present application, a gate of the switching device serves as a control terminal, and the ground terminal of the pulse width modulation circuit and the source of the switching device Q0 are connected to the ground node.

In one example of the present application, he pulse width modulation circuit is a PWM controller.

According to another aspect of the present application, a switched-mode power supply is provided, comprising the driving circuit for the switching device described in any of the above.

According to the driving circuit for the switching device and the switched-mode power supply in the examples of the present application, the resistor-capacitor series circuit can smooth and delay the high-level pulse signal to reduce the edge slope of the high-level pulse signal, thereby reducing the frequency component of the high-level pulse signal, ensuring smooth transition of the control terminal driving signal, avoiding high-frequency oscillation caused by excessive turn-on speed, avoiding electromagnetic interference and noise, also avoiding ringing in the circuit, and reducing the risk of breakdown to the switching device.

### Brief description of drawings

By describing the examples of the present application in more detail in conjunction with the accompanying drawing, the above and other objectives, features, and advantages of the present application will become more apparent. The accompanying drawings are used for providing a further understanding of the examples of the present application, constitute a part of the description, and are used with the examples of the present application for interpreting the present application, rather than limiting the present application. In the accompanying drawings, the same reference numerals usually represent the same components or steps.
FIG. 1 illustrates a schematic structural diagram of a driving circuit for a switching device.
FIG. 2 illustrates a schematic structural diagram of a driving circuit for a switching device according to an aspect of the present application.

### Detailed description

In the following description, a lot of specific details are provided to provide a more thorough understanding of the present application. However, it is obvious to those skilled in the art that the present application can be implemented without one or more of these details. In other examples, in order to avoid confusion with the present application, some well-known technical features in this art are not described.

It should be understood that the present application can be implemented in different forms and should not be interpreted as limited to the examples provided herein. On the contrary, providing these examples will make the disclosure thorough and complete, and fully convey the scope of the present application to those skilled in the art. In the accompanying drawings, the dimensions and relative sizes of layers and regions may be exaggerated for clarity. The same reference numerals throughout indicate the same elements.

The terms used here are only intended to describe specific examples and not to serve as limitations of the present application. When used here, the singular forms of "a", "an", and "said/the" also include plural forms, unless the context clearly indicates otherwise. It should also be understood that the terms "compose" and/or "include", when used in the description, determine the presence of the described features, integers, operations, elements, and/or components, but do not exclude the presence or addition of one or more other features, integers, operations, elements, components, and/or groups. When used here, the term "and/or" includes any and all combinations of the listed items.

In a commonly used driving circuit for a switching device, due to parasitic parameters of the switching device, in high-speed switching applications, gate voltage of the switching device increases rapidly at the moment of turn-on, and charges in its gate-drain capacitor and gate-source capacitor accumulate rapidly. This process involves rapid changes in voltage and current, resulting in high-frequency components inside the switching device. Meanwhile, the drain inductor and source inductor of the switching device, as well as inductors between wires, can also have an impact. These inductors and capacitors together may form a resonant circuit inside the switching device, resulting in high-frequency oscillations at the moment of turn-on. These high-frequency oscillations may enable signals to rapidly change in voltage and current inside the switching device, resulting in electromagnetic interference and noise, and periodic oscillations in the circuit to form ringing. Moreover, excessive peak voltage poses a risk of breakdown to the switching device.

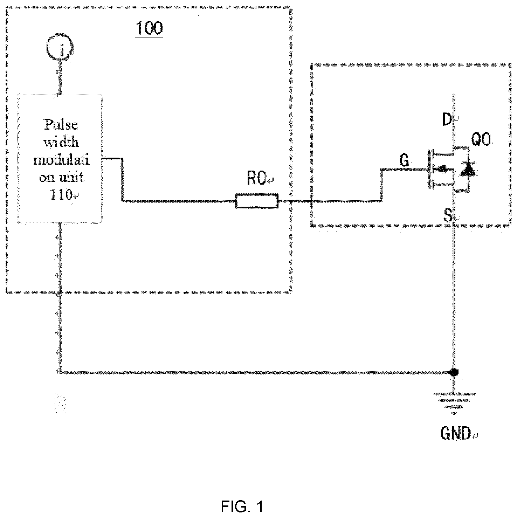

FIG. 1 illustrates a schematic structural diagram of a driving circuit for a switching device. In FIG. 1, a driving circuit 100 comprises a pulse width modulation unit 110 and a resistor R0. An input terminal i of the pulse width modulation unit 110 is connected to an external power supply device. An output terminal of the pulse width modulation unit 110 is connected to a first terminal of the resistor R0, a second terminal of the resistor R0 is connected to a gate G of the switching device Q0, and a ground terminal of the pulse width modulation unit 110 and a source S of the switching device Q0 are connected to a ground node.

In the driving circuit 100, it is not appropriate for a pulse signal output by the pulse width modulation unit 110 to directly drive the gate G of the switching device Q0. Because the rise time of the pulse signal may be very short, voltage and current change rapidly at the moment of turning on (e.g., connecting) the switching device Q0, resulting in electromagnetic interference and noise. Periodic oscillation in the driving circuit 100 may form ringing. Moreover, excessive peak voltage poses a risk of breakdown to the switching device Q0. In addition, when turned off, the switching device Q0 is prone to be turned on by mistake by external interference and the time for turning off the switching device Q0 is relatively long.

In order to fully understand the present application, a detailed structure will be presented in the following description to illustrate the technical solution provided in the present application. Examples of the present application are described in detail below. However, in addition to these detailed descriptions, the present application may further have other implementations.

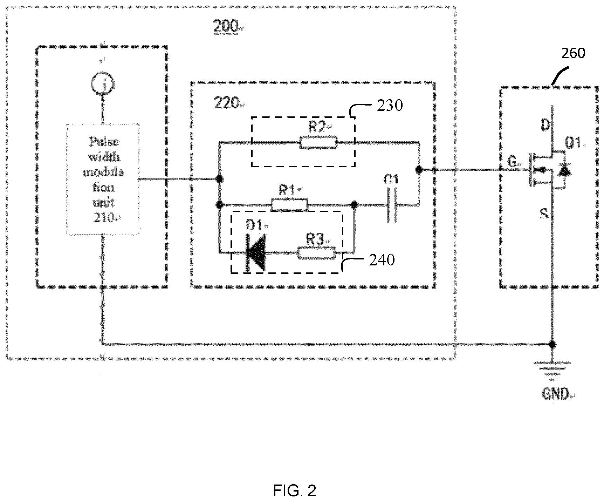

A driving circuit for a switching device according to an example of the present application is described below with reference to FIG. 2. As shown in FIG. 2, a driving circuit 200 for a switching device (e.g., a switching device 260) comprises a pulse width modulation unit 210 and a first waveform conversion circuit 220. An input terminal of the pulse width modulation unit 210 is configured to be connected to an external power supply device, an output terminal of the pulse width modulation unit 210 is connected to an input terminal of the first waveform conversion circuit 220, and an output terminal of the waveform conversion circuit 220 is connected to a control terminal of the switching device Q1. The first waveform conversion circuit 220 comprises a resistor-capacitor series circuit (also referred to as an RC series circuit), the pulse width modulation unit 210 is configured to output a first level pulse signal for turning on the switching device, and the resistor-capacitor series circuit is configured to control (e.g., reduce) an edge slope (e.g., edge rate) of the first level pulse signal. Controlling an edge slope may comprise controlling the rate at which the signal transitions between its high and low voltage levels. Specifically, it may involve modifying the sharpness or steepness of the rising and falling edges of the pulse.

The pulse width modulation unit 210 comprises one or more electronic components (e.g., timer, resistor, capacitor, diode) configured to generate a pulse width modulation (PWM) signal, and can adjust the width of a pulse signal based on the result of comparison between an input signal and a clock signal, so as to control an output signal.

In one example, the pulse width modulation unit 210 may be a PWM controller, which is not limited herein. In one example, the PWM signal output by the pulse width modulation unit 210 may be a square wave of high and low levels. The square wave of high and low levels may be composed of two stable alternating levels, usually a high-level pulse signal and a low-level pulse signal form a square-like waveform. The time duration of the high-level pulse signal and the low-level pulse signal may depend on the duty cycle of the square wave. The high-level pulse signal may be referred to as the first level pulse signal, and the low-level pulse signal may be referred to as a second level pulse signal. When the PWM signal output by the pulse width modulation unit 210 is a high-level pulse signal, the voltage at the control terminal of the switching device Q1 increases, so that the switching device Q1 is turned on. When the PWM signal output by the pulse width modulation unit 210 is a low-level pulse signal, the voltage at the control terminal of the switching device Q1 decreases, so that the switching device Q1 is turned off.

In one example, when the pulse width modulation unit 210 outputs a high-level pulse signal and the high-level pulse signal passes through the RC series circuit, due to the charging and discharging characteristics of a capacitor in the RC series circuit, the high-level pulse signal can be smoothed and delayed, so that the edge slope of the high-level pulse signal gradually decreases, thereby reducing the frequency component of the high-level pulse signal, ensuring smooth transition of a control terminal driving signal, avoiding high-frequency oscillation caused by excessive turn-on speed, avoiding electromagnetic interference and noise, also avoiding ringing in the circuit, and reducing the risk of breakdown to the switching device Q1.

Based on this, the present application describes a driving circuit 200 for a switching device capable of waveform conversion of PWM signals. According to the driving circuit 200 for the switching device in the present application, the RC series circuit can smooth and delay the high-level pulse signal to reduce the edge slope of the high-level pulse signal, thereby reducing the frequency component of the high-level pulse signal, ensuring smooth transition of the control terminal driving signal, avoiding high-frequency oscillation caused by excessive turn-on speed, avoiding electromagnetic interference and noise, also avoiding ringing in the circuit, and reducing the risk of breakdown to the switching device Q1.

In one example, the switching device Q1 may be an MOSFET (Metal Oxide Semiconductor Field Effect Transistor), a JFET (Junction Field-Effect Transistor), an IGBT (Insulated Gate Bipolar Transistor), or the like, which is not limited. Correspondingly, the control terminal may refer to the gate G of the switching device such as MOSFET, JFET, or IGBT.

In one example, the input terminal of the pulse width modulation unit 210 is configured to be connected to an external power supply device. The external power supply device supplies power to the pulse width modulation unit 210, so that the pulse width modulation unit 210 outputs PWM signals. The external power supply device may be a power source, a battery, a power supply circuit, or the like, which is not limited herein.

In one example, the output terminal of the switching device Q1 is configured to be connected to a voltage stabilizing input device. Therefore, after receiving the PWM signal input by the pulse width modulation unit 210, the switching device Q1 can be turned on or off to stabilize the output voltage for applications that require stable output voltage, such as a power supply and a DC-DC converter. The voltage stabilizing input device may be a voltage stabilizing circuit, an electronic component that requires input voltage stabilization, or the like, which is not limited.

For MOSFET and JFET, their output terminals may refer to the drain D of the field-effect transistor; for IGBT, its collector is the output terminal of IGBT for carrying current; for other types of switching devices, the determination of their output terminals may be analogized to the above introduction, and will not be repeated here.

In one example, as shown in FIG. 2, the ground terminal of the pulse width modulation unit 210 and the input terminal of the switching device Q1 are connected to the ground node.

For MOSFET and JFET, their output terminals may refer to the source S of the field-effect transistor; for IGBT, its emitter is the input terminal of IGBT; for other types of switching devices, the determination of their input terminals may be analogized to the above introduction, and will not be repeated here.

In one example, as shown in FIG. 2, the resistor-capacitor series circuit comprises a first resistor R1 and a first capacitor C1. A first terminal of the first resistor R1 is connected to the output terminal of the pulse width modulation unit 210, a second terminal of the first resistor R1 is connected to a first terminal of the first capacitor C1, and a second terminal of the first capacitor C1 is connected to the control terminal of the switching device Q1. An on branch constituted by the first resistor R1 and the first capacitor C1 can be used for providing a maximum transient current.

Specifically, when the pulse width modulation unit 210 outputs a high-level pulse signal, the first capacitor C1 can smooth and delay the high-level pulse signal to generate a slowly rising voltage signal, which is input from the output terminal of the RC series circuit to the gate G of the switching device Q1 as a driving signal for the gate G of the switching device Q1. Thus, the edge slope of the high-level pulse signal can be gradually changed by the charging and discharging characteristics of the first capacitor C1, and the turn-on speed of the switching device Q1 can be reduced, thereby avoiding high-frequency oscillation of the switching device Q1, effectively reducing the power consumption and noise of the switching device Q1, and improving the stability and efficiency of the driving circuit 200.

The first resistor R1 can play a role in limiting the current in the resistor-capacitor series circuit. When the pulse width modulation unit 210 outputs a high-level pulse signal, a gate capacitor of the switching device Q1 begins to charge, and the first resistor R1 limits the magnitude of the charging current, thereby avoiding excessive current impact on the gate G of the switching device Q1 and protecting the switching device Q1 and the driving circuit 200 from excessive current impact and damage.

In one example, the driving circuit 200 comprises a second waveform conversion circuit 230, the second waveform conversion circuit comprises a second resistor R2, and the second resistor R2 is connected in parallel to two ends of the resistor-capacitor series circuit. An on branch constituted by the second resistor R2 can be used for providing a minimum static current.

Specifically, a first terminal of the second resistor R2 is connected to the output terminal of the pulse width modulation unit 210 and the first terminal, connected to the output terminal of the pulse width modulation unit, of the first resistor R1, and a second terminal of the second resistor R2 is connected to the gate G of the switching device Q1 and the second terminal, connected to the first capacitor, of the first capacitor C1.

Because the second resistor R2 is connected in parallel to two ends of the RC series circuit, when the RC series circuit smooths and delays the high-level pulse signal, a portion of the voltage divided by the second resistor R2 falls onto the second resistor R2, which can further reduce the rise and fall speed of the gate G driving signal, further reduce the switching speed of the switching device Q1 and improve the stability and efficiency of the driving circuit 200.

Moreover, connecting the first resistor R1 and the second resistor R2 in parallel can reduce the overall resistance of the waveform conversion circuit 220, thereby providing a high enough charging current to raise the voltage between the gate G and source S of the switching device Q1 to a desired value.

In one example, the driving circuit 200 comprises a third waveform conversion circuit 240, the third waveform conversion circuit 240 comprises a discharge circuit, and the discharge circuit is connected in parallel to two ends of the first resistor R1. When the pulse width modulation unit 210 outputs a low-level pulse signal to turn off the switching device Q1, the low-level pulse signal can be discharged by the discharge circuit.

In one example, as shown in FIG. 2, the discharge circuit comprises a first diode D1 and a third resistor R3, a negative terminal of the first diode D1 is connected to the first terminal R1, connected to the output terminal of the pulse width modulation unit 210, of the first resistor R1, a positive terminal of the first diode D1 is connected to a first terminal of the third resistor R3, and a second terminal of the third resistor R3 is connected to the second terminal, connected to the first capacitor, of the first resistor R1.

Specifically, the first diode D1 and the third resistor R3 can constitute a negative pressure fast discharge circuit. When the switching device Q1 is turned off, the conduction characteristics of the first diode D1 can provide a low-impedance path, so that the capacitor between the gate G and source S of the switching device Q1 is quickly discharged, to improve the switching speed of the switching device Q1 and avoid the risk of forming a resonant circuit by parasitic capacitors and inductors, thereby reducing the integral sum of a current and voltage superposition region, effectively shortening the turn-off time and reducing the turn-off loss. Moreover, the negative pressure fast discharge circuit constituted by the first diode D1 and the third resistor R3 can effectively avoid mistaken turn-on of the switching device Q1 by external interference.

In addition, the third resistor R3 can provide certain resistance to the negative pressure discharge circuit, thereby avoiding burnout of the pulse width modulation unit 210 due to excessive current when turned off.

According to another aspect of the present application, a switched-mode power supply is further provided, comprising a driving circuit for a switching device.

The driving circuit for the switching device may be implemented as the driving circuit 200 for the switching device described earlier, which can be referred to in the previous description and will not be repeated here.

The switched-mode power supply (SMPS) is an efficient power supply device, which can convert input power into stable output power and is commonly used in various electronic devices (such as computers, mobile phone chargers, LED lights, and televisions) and power systems. Compared to conventional linear power supplies, the switched-mode power supply has higher energy conversion efficiency, smaller size and weight, and better power regulation performance.

The basic working principle of the switched-mode power supply is to periodically turn on and off the switching device to convert direct current (DC) or alternating current (AC) voltage of the input power into high-frequency pulse signals, which are then converted into stable output voltage or current by components such as a filter and a transformer.

In summary, according to the driving circuit for the switching device and the switched-mode power supply in the present application, the resistor-capacitor series circuit can smooth and delay the high-level pulse signal to reduce the edge slope of the high-level pulse signal, thereby reducing the frequency component of the high-level pulse signal, ensuring smooth transition of the control terminal driving signal, avoiding high-frequency oscillation caused by excessive turn-on speed, avoiding electromagnetic interference and noise, also avoiding ringing in the circuit, and reducing the risk of breakdown to the switching device.

Although examples are described here with reference to the accompanying drawings, it should be understood that the above examples are merely exemplary and are not intended to limit the scope of the present application. Those of ordinary skill in the art can make various changes and modifications without deviating from the scope and spirit of the present application. All these changes and modifications are intended to be included within the scope of the present application as claimed in the appended claims.

Similarly, it should be understood that in order to simplify the present application and help understand one or more aspects of the application, various features of the present application are sometimes grouped together into a single example, figure, or description thereof in the description of the exemplary examples of the present application. However, the method of the present application should not be interpreted as reflecting the intention that the protected present application requires more features than those explicitly stated in each claim. More precisely, as reflected in the corresponding claims, the application point lies in the ability to solve the corresponding technical problems with fewer than all the features of a single disclosed example. Therefore, the claims that follow specific implementations are explicitly incorporated into the specific implementations, where each claim serves as a separate example of the present application.

In addition, those skilled in the art can understand that although some examples described herein include some features included in other examples rather than other features, the combination of features of different examples implies that they fall within the scope of the present application and form different examples. For example, in the claims, any one of the examples claimed for protection can be used in any combination.

It should be noted that the above examples illustrate the present application rather than limit the present application, and those skilled in the art can design alternative examples without departing from the scope of the appended claims. In the claims, any reference numerals between parentheses should not be constructed as limitations on the claims. The use of terms such as first, second, and third does not indicate any order. These terms can be interpreted as names.

## Claims

1. A driving circuit for a switching device, comprising:
- a pulse width modulation circuit comprising an input terminal and an output terminal; and
- a resistor-capacitor series circuit comprising an input terminal and an output terminal, wherein:
- the output terminal of the pulse width modulation circuit is connected to an input terminal of the resistor-capacitor series circuit,
- the output terminal of the resistor-capacitor series circuit is connected to a control terminal of the switching device,
- the pulse width modulation circuit is configured to output a level pulse signal for turning on the switching device, and
- the resistor-capacitor series circuit is configured to reduce an edge slope of the level pulse signal.

2. The driving circuit for the switching device according to claim 1, wherein:
- the resistor-capacitor series circuit comprises a first resistor and a first capacitor,
- a first terminal of the first resistor is connected to the output terminal of the pulse width modulation circuit,
- a second terminal of the first resistor is connected to a first terminal of the first capacitor, and
- a second terminal of the first capacitor is connected to the control terminal of the switching device.

3. The driving circuit for the switching device according to claim 2, further comprising a waveform conversion circuit comprising a second resistor, wherein the second resistor is connected in parallel to the first resistor and the first capacitor.

4. The driving circuit for the switching device according to claim 2 or 3, further comprising a discharge circuit connected in parallel to the first resistor.

5. The driving circuit for the switching device according to claim 4, wherein:
- the discharge circuit comprises a diode and a third resistor,
- a negative terminal of the diode is connected to the first terminal of the first resistor,
- a positive terminal of the diode is connected to a first terminal of the third resistor, and
- a second terminal of the third resistor is connected to the second terminal of the first resistor.

6. The driving circuit for the switching device according to claim 4 or 5, wherein:
- the pulse width modulation circuit is configured to output a second level pulse signal for turning off the switching device, and
- the second level pulse signal is discharged by the discharge circuit, wherein a level value of the level pulse signal is higher than that of the second level pulse signal.

7. The driving circuit for the switching device according to any of the preceding claims, wherein the input terminal of the pulse width modulation circuit is connected to an external power supply device.

8. The driving circuit for the switching device according to any of the preceding claims, wherein:
- an output terminal of the switching device is connected to a voltage stabilizing input device, and
- a ground terminal of the pulse width modulation circuit and an input terminal of the switching device are connected to a ground node.

9. The driving circuit for the switching device according to any of the preceding claims, wherein the switching device comprises one of a metal oxide semiconductor field effect transistor (MOSFET), a junction field-effect transistor (JFET), or an insulated gate bipolar transistor (IGBT).

10. The driving circuit for the switching device according to any of the preceding claims, wherein the control terminal comprises a gate.

11. A driving circuit for a switching device, comprising:
- a pulse width modulation circuit configured to send a level pulse signal to the switching device; and
- a waveform conversion circuit connected to the pulse width modulation circuit, wherein the waveform conversion circuit comprises:
- first resistor and a first capacitor connected in series,
- a second resistor connected in parallel to the first resistor and the first capacitor, and
- a diode and a third resistor connected in parallel to the first resistor.

12. The driving circuit for the switching device according to claim 11, wherein the waveform conversion circuit is configured to control an edge slope of the level pulse signal and/or to reduce an edge slope of the level pulse signal.

13. The driving circuit for the switching device according to claim 11 or 12, wherein the pulse width modulation circuit is configured to send a second level pulse signal to the switching device and a level value of the level pulse signal is higher than that of the second level pulse signal and/or the pulse width modulation circuit is connected to an external power supply device.

14. The driving circuit for the switching device according to any of claims 11 to 13, wherein at least one of the following is provided:
- an output terminal of the switching device is connected to a voltage stabilizing input device;
- a ground terminal of the pulse width modulation circuit and an input terminal of the switching device are connected to a ground node; and
- the waveform conversion circuit is connected to a control terminal of the switching device.

15. The driving circuit for the switching device according to any of claims 11 to 14, wherein the switching device comprises at least one of a metal oxide semiconductor field effect transistor (MOSFET), a junction field-effect transistor (JFET), an insulated gate bipolar transistor (IGBT), and a gate connected to the waveform conversion circuit.
